# EUROPÄISCHE PATENTANMELDUNG

(11) **EP 1 783 234 A2**
(43) Veröffentlichungstag der Anmeldung: **09.05.2007**
(21) Anmeldenummer: 07102972.2
(22) Anmeldetag: 26.09.2002
(51) Int. Cl.: C21D 1/00

(54) **Verfahren zum Herstellen von Produkten durch Umformen bei erhöhten Temperaturen**

(62) Teilanmeldung aus: 02021566.1
(71) Anmelder: ThyssenKrupp Steel AG, 47166 Duisburg (DE)
(72) Erfinder: Engl, Bernhard, Dr.-Ing., 44267, Dortmund (DE); Heller, Thomas, Dr.-Ing., 47229, Duisburg (DE); Horn, Klaus Dieter, Ing., 44369, Dortmund (DE); Stich, Günter, Dipl.-Ing., 44869, Bochum (DE); Meurer, Manfred, 47495, Rheinberg (DE); Steinhorst, Michael, Dr.-Ing., 45355, Essen (DE)
(74) Vertreter: Cohausz & Florack

(57) **Zusammenfassung**

Die Erfindung betrifft ein Verfahren, mit dem sich auf einfache Weise Produkte durch Warmverformen kostengünstig herstellen lassen, bei denen trotz bei komplexer Formgebung und hoher Festigkeit ihres Werkstoffs die Gefahr der Entstehung übermäßiger Spannungen vermieden ist. Dies wird erfindungsgemäß dadurch erreicht, dass das Stahlblech auf eine Verformungstemperatur, die 450 °C bis 700 °C beträgt, erwärmt wird, dass das auf Verformungstemperatur erwärmte Stahlblech zu dem Produkt umgeformt wird und dass das Produkt ungesteuert und langsam auf Raumtemperatur abgekühlt wird, wobei die Eigenschaften des Werkstoffs, aus dem der Rohling hergestellt ist, und die Verformungstemperatur so aufeinander abgestimmt sind, dass das erhaltene Produkt hinsichtlich mindestens eines Kennwerts seiner mechanischen Eigenschaften gegenüber dem Rohling verbessert ist.

## Beschreibung

Die Erfindung betrifft ein Verfahren zum Herstellen von Produkten aus einem mindestens auf einer seiner Außenflächen verzinkten Stahlblechs durch Umverformen bei erhöhten Temperaturen.

Der Vorteil einer Warmverformung liegt darin, dass sich trotz hoher Umformgrade bei geringen Umformkräften auf einfache Weise komplexe Formen herstellen lassen. So ist es beispielsweise möglich, durch Warmverformung beispielsweise auch solche Bleche tiefzuziehen, die aufgrund ihrer großen Blechdicke oder ihrer hohen Festigkeit nur mit großem Aufwand oder gar nicht kaltverformt werden können. So können die immer höheren Anforderungen erfüllt werden, die insbesondere bei der Verarbeitung von hochfesten Stahlwerkstoffen an das Umformvermögen einerseits und die Festigkeit andererseits gestellt werden.

Als problematisch bei der Warmverformung erweist sich allerdings, dass es an der Oberfläche des auf Verformungstemperatur erwärmten Bauteils zur Zunderbildung infolge von Oxidation des metallischen Werkstoffs kommt, sobald das heiße Bauteil mit der Umgebungsluft in Berührung kommt. Besonders anfällig erweisen sich in diesem Zusammenhang Stahlwerkstoffe. Der harte, wenig geschmeidige Oxidfilm bricht bei der im heißen Zustand des Rohlings durchgeführten Warmverformung. Die von der Bauteiloberfläche abplatzenden Zunderstücke behindern den Verformungsvorgang und verursachen eine erhebliche Verschlechterung der Oberflächenbeschaffenheit. Gleichzeitig bildet sich im Bereich der abgeplatzten Zunderstücke sofort wieder neues Oxid, das vielfach wiederum der Verformung nicht folgen kann, aufbricht und zu einer Verstärkung des durch den Zunder hervorgerufenen Schadens führt.

In der EP 1 013 785 A1 oder der FR 1.297.906 ist für die Heißverformung von Stahlrohlingen vorgeschlagen worden, die jeweils warmzuverformenden Rohlinge vor der Warmverformung mit einem metallischen Schutzüberzug zu versehen, der die Oberfläche des Produktes schützt.

Die Rohlinge werden gemäß den bekannten Verfahren auf eine Warmverformungstemperatur gebracht, die üblicherweise im Bereich von 850 °C bis 1250 °C liegt. So wird beispielsweise gemäß der EP 1 013 785 A1 ein aus einem Stahlwerkstoff bestehender Blechrohling, nachdem er mit einer 9 - 10 Gew.-% Si, 2 - 3,5 % Fe und als Rest Al und unvermeidbare Verunreinigungen oder einer 2 - 4 Gew.-% Fe und als Rest Al und unvermeidbare Verunreinigungen enthaltenden Schutzschicht überzogen worden ist, auf eine Temperatur von 950 °C erwärmt und im heißen Zustand zu einem Bauteil tiefgezogen.

In vergleichbarer Weise werden gemäß der FR 1.297.906 die Rohteile mit Al-Si-Legierungen oder Al, Cu und Zn enthaltenden Legierungen überzogen, bevor sie auf die hohe, oberhalb von 850 °C liegende Warmverformungstemperatur gebracht werden. Wenn die Rohling über ihre gesamte Masse auf die gewünschte Temperatur gebracht worden sind, wird er beispielsweise in einem Schmiedevorgang warmverformt, wobei der Schmiedevorgang selbst bei Temperaturen durchgeführt wird, die unterhalb der A_{C3}-Temperatur, beispielsweise bei 700 °C oder 600 °C, liegen.

Um den Verformungsvorgang zu unterstützen und ein Ankleben des heißen Werkstücks an den Wandungen des Gesenks zu vermeiden, wird in der FR 1.297.906 vorgeschlagen, die Innenflächen des Gesenks mit einem Schmierstoff, wie Graphit oder ähnlichem, zu benetzen. Es hat sich jedoch gezeigt, dass sich bei Verwendung der bekannten Überzüge nicht nur ein wirkungsvoller Schutz gegen Oxidation während der Warmverformung erreichen lässt, sondern dass diese Überzüge selbst trotz des Umstandes, dass sie im kalten Zustand spröde und bei einer Kaltverformung anfällig für Bruch und Rissbildung sind, während der Warmverformung eine Schmierfunktion erfüllen.

Gemäß den bekannten Verfahren schließt sich an die Warmverformung jeweils eine gesteuerte, beschleunigte Abkühlung an, um einerseits dem Stahlwerkstoff und andererseits dem Überzug eine erhöhte Oberflächenhärte zu verleihen. Der mit einer solchen Abschreckung verbundene apparative Aufwand ist erheblich und führt zu deutlich erhöhten Betriebskosten. Hinzukommt, dass es im Zuge der Abschreckung zum Aufbau von erheblichen Spannungen im fertig verformten Bauteil kommen kann, die sich für die Weiterverarbeitung als besonders kritisch erweisen können.

Die Aufgabe der Erfindung bestand daher darin, ein Verfahren zu schaffen, mit dem sich auf einfache Weise Produkte durch Warmverformen kostengünstig herstellen lassen, bei denen trotz bei komplexer Formgebung und hoher Festigkeit ihres Werkstoffs die Gefahr der Entstehung übermäßiger Spannungen vermieden ist.

Diese Aufgabe ist erfindungsgemäß durch das in Anspruch 1 angegebene Verfahren gelöst worden. Vorteilhafte Ausgestaltungen dieses Verfahrens sind in den abhängigen Ansprüchen angegeben.

Gemäß der Erfindung werden als Rohlinge auf mindestens einer ihrer Außenflächen verzinkte Stahlbleche bei einer im Bereich von 450 - 700 °C liegenden Temperatur warmverformt, die zwar höher als die Raumtemperatur, jedoch verglichen mit dem Stand der Technik relativ niedrig ist.

Der Grundgedanke der Erfindung besteht dabei darin, dass die vor der Warmverformung vorhandenen Eigenschaften des für die Herstellung des Stahlblech-Rohlings verwendeten Werkstoffs, insbesondere seine Zusammensetzung und sein Gefüge, und der Parameter "Temperatur" bei der Umformung so aufeinander abgestimmt sind, dass das erhaltene Produkt die geforderte hohe Festigkeit besitzt, ohne dass es dazu einer gesteuerten, intensiven Abkühlung nach dem Umformvorgang bedarf. Auf diese Weise kann auf das beim Stand der Technik zur Erhöhung seiner Härte jeweils erforderliche Abschrecken des Produkts nach der Warmverformung verzichtet werden.

Stattdessen schreibt die Erfindung im Anschluss an die Warmverformung eine ungesteuerte, langsam ablaufende Abkühlung vor. Durch diese langsame Abkühlung wird erreicht, dass das erhaltene hochfeste Produkt nach dem Abkühlen arm bzw. frei an inneren Spannungen ist und als solches problemlos weiterverarbeitet werden kann.

Die Legierung des verarbeiteten metallischen Werkstoffs und die für die Umformung gewählte Temperatur sind dabei gemäß einer vorteilhaften Ausgestaltung der Erfindung so aufeinander abgestimmt, dass der Kennwert der mechanischen Eigenschaften des Produktes nach Beendigung des Umformvorgangs im Zuge der ungesteuerten Abkühlung im Wesentlichen konstant bleibt oder sogar ansteigt, ohne dass dazu ein Abschrecken erforderlich ist.

Besonders vorteilhaft lässt sich die Erfindung für die Verarbeitung von Stahlwerkstoffen einsetzen, die als Rohlinge in Form von Warmband oder Kaltband bzw. daraus erzeugten Blechen verarbeitet werden.

Demgemäß lässt sich die Erfindung auf niedrig legierte Stähle mit Kohlenstoffgehalten von unter 0,10 Gew.-%, Kohlenstoffstähle mit oberhalb von 0,10 Gew.-% liegenden C-Gehalten, niedrig- und höher-legierte Stähle mit jeweils einzeln oder in Kombination vorhandenen Gehalten an C, Si, Mn, Al, N, P, W, Cr, Mo, Ni, V, Nb, Ti, B anwenden.

Durch die Erwärmung auf Umformtemperatur vor der Umformung wird die Umformfestigkeit des jeweils verarbeiteten Werkstoffs deutlich vermindert, während sein Formänderungsvermögen, z.B. die Bruchdehnung, ebenso signifikant erhöht wird. Die jeweils gewählten Umformtemperaturen sind dabei deutlich gegenüber der Raumtemperatur erhöht. Gleichzeitig liegen die Umformtemperaturen jedoch unterhalb der beim Stand der Technik üblicherweise gewählten Warmverformungstemperaturen. So sieht die Erfindung vor, dass die Warmverformung in einem 450 °C bis 700 °C betragenden Temperaturintervall durchgeführt wird, wobei sich insbesondere bei der Verarbeitung von Stahlwerkstoffen gute Arbeitsergebnisse einstellen, wenn bei maximalen Temperaturen von bis zu 650 °C oder 600 °C gearbeitet wird.

Durch die Warmumformung bei erhöhter Temperatur sollen zwei wichtige Effekte erzielt werden. Zum einen soll eine verringerte Umformkraft gegenüber der Umformung bei Raumtemperatur erreicht werden. Zum anderen sollen durch die erhöhte Temperatur die Werkstoffeigenschaften eingestellt werden. Eine Besonderheit der Erfindung ist somit die Kombination von Temperatur- und Verformungseinflüssen zur Einstellung der gewünschten mechanischen Eigenschaften. Die Höhe der Verformungstemperatur richtet sich somit nach der für die Formgebung erforderlichen Umformkraft und wird gleichzeitig durch die gewünschten Eigenschaften des herzustellenden Produkts bestimmt.

Entscheidend ist dabei, dass die mechanischen Eigenschaften des erhaltenen Produkts durch die abschließende Abkühlung nicht mehr beeinflusst werden. Dies kann beispielsweise durch eine Abkühlung des fertig umgeformten Produkts an ruhender Luft erfolgen. Auf diese Weise werden erfindungsgemäß spannungsarme bzw. spannungsfreie hochfeste und komplex geformte Produkte erzeugt, ohne dass dazu zusätzliche, kostspielige Maßnahmen, wie eine gezielte Abschreckung mit anschließendem gesonderten Spannungsarmglühen, erforderlich sind.

Um die Ausprägung einer bestimmten mechanischen Eigenschaft des fertig umgeformten Produkts, insbesondere von dessen Festigkeit, zu unterstützen, ist es gemäß einer ersten Variante der Erfindung vorgesehen, den Rohling nach Erreichen der Verformungstemperatur für ein bestimmtes Zeitintervall auf der Verformungstemperatur zu halten, bevor er warmumgeformt wird. Durch das dem Umformvorgang vorgeschaltete Halten des Rohlings bei der Verformungstemperatur wird der Werkstoff des Rohlings in einen Zustand gebracht, in dem sich die im Zuge des Umformvorgangs ausgeübten Umformkräfte und Verformungsvorgänge im Hinblick auf die Festigkeitssteigerung optimal auswirken. Abhängig von den Eigenarten des jeweils verarbeiteten Werkstoffs kann es für den selben Zweck ebenso sinnvoll sein, den Rohling zunächst auf eine über der Verformungstemperatur liegende Überhöhungstemperatur aufzuheizen, von der aus er anschließend auf die Verformungstemperatur abgekühlt wird, bei der dann die Umformung durchgeführt wird.

Besonders effektiv lässt sich das erfindungsgemäße Verfahren bei der Verarbeitung von Stahlwerkstoffen einsetzen, wenn als Rohling ein Warm- oder Kaltband zur Verfügung steht. Die Warmverformung ermöglicht es insbesondere, Warmbänder von großer Dicke trotz hoher Umformgrade auf einfache Weise zu Produkten mit komplexer Formgebung umzuformen.

Bei dem erfindungsgemäß erzeugten Produkt kann es sich um ein Endprodukt handeln, das ein fertiges Bauteil darstellt und keiner weiteren Verformung mehr unterzogen wird, oder um ein Zwischenprodukt, das im Anschluss an die Abkühlung weitere Verarbeitungsschritte durchläuft. Als weitere Maßnahme, durch die die Festigkeitseigenschaften und Maßhaltigkeit des erfindungsgemäß erhaltenen Produkts weiter gesteigert werden können, sieht die Erfindung in diesem Zusammenhang vor, dass das fertig warmumgeformte Produkt nach dem Abkühlen bei Raumtemperatur einer weiteren Verformung unterzogen werden kann.

Besonders vorteilhaft wirkt sich bei der Erfindung aus, dass die erfindungsgemäß verarbeiteten Rohlinge vor ihrer Warmverformung mindestens auf einer ihrer Außenflächen mit einem Zinküberzug versehen worden sind. Wie beim Stand der Technik schützt dieser Überzug die Rohlinge während der Erwärmung und der Umformung vor Oxidation. Darüber hinaus kann auch beim erfindungsgemäßen Verfahren der Überzug während des Umformvorgangs eine Schmierfunktion übernehmen.

Die Erfindung gestattet insbesondere durch Anwendung der niedrigen Temperaturen bei der Umformung des Rohlings das Auftragen von Überzügen und Schichtsystemen, die gegenüber dem Stand der Technik deutlich verbesserte Eigenschaften besitzen.

Die Erfindung sieht in diesem Zusammenhang als vorteilhafte Ausgestaltungen verschiedene Varianten von Überzügen vor, die auf den jeweiligen Verwendungszweck des erhaltenen Produkts abgestimmte Eigenschaften des Überzugs zur Verfügung stellen.

Gemäß einer ersten dieser Varianten ist vorgesehen, dass der Überzug nicht metallisch ist und vor der Warmverformung bereits eine hohe Härte besitzt, die während der Warmumformung und der anschließenden Abkühlung im Wesentlichen konstant bleibt.

Gemäß einer zweiten Variante wird auf den ersten harten Überzug eine metallische Deckschicht aufgebracht, die weich ist und diese Eigenschaft während der Warmumformung und der anschließenden Abkühlung im Wesentlichen konstant beibehält.

Gemäß einer dritten Variante wird der Rohling mit einer Beschichtung versehen, bei der während des Haltens bei Umformtemperatur durch Diffusion mit dem Substrat und aufgebrachten Schichten und / oder durch die Reaktionen mit der Umgebungsatmosphäre die Schichteigenschaften entwickelt werden.

Bei der ersten Variante besitzt das auf den für die Beschichtung vorzugsweise als Band- oder Blechmaterial ausgebildeten Rohling aufgebrachte Schichtsystem von Anfang an eine hohe Härte, die im Zuge der Erwärmung und Verformung im Wesentlichen keine Veränderung erfährt. Eine solche Schicht kann bei Verarbeitung eines Stahlbands beispielsweise dadurch erzeugt werden, dass eine Oxidschicht auf das Stahlband aufgebracht wird, die neben den üblichen unvermeidbaren Verunreinigungen aus Si, Al, Cr oder Ti sowie Mischungen dieser Elemente gebildet ist. Zum selben Zweck können auch Nitridschichten auf Stahlband aufgebracht werden, die aus Si, Cr, Ti, B oder Mischsystemen dieser Elemente erzeugt werden. Denkbar ist es darüber hinaus, eine nicht metallische, ihre Eigenschaften im Zuge der Warmverformung nicht verändernde Beschichtung eines Stahlbands durch Carbidschichten zu bewerkstelligen, die aus B, Ti, Nb, W oder Si sowie Mischungen dieser Elemente bestehen können. Schließlich lässt sich ein solcher Überzug auch durch Aufbringen einer Me-N-e-O-, einer Me-C-O- oder einer Me-N-C-Schicht erzeugen, wobei mit "Me" eines der Elemente Si, Al, Cr, Ti, B, Nb oder W bezeichnet ist. Die Schichtdicke wird dabei regelmäßig jeweils 1 nm bis 1000 nm betragen, wobei erfindungsgemäß jeweils Schichtdicken von 10 nm bis 100 nm bevorzugt werden.

Die gemäß der ersten Variante der Erfindung vorgesehenen Überzüge sind nichtmetallisch. Sie besitzen eine ausgezeichnete Stabilität und eine hohe Härte. Sie schützen die Oberfläche vor Oxidation und Korrosion. Gleichzeitig verleihen sie der Oberfläche hervorragende tribologische Eigenschaften, die u.a. den Umformprozess im Umformwerkzeug während der Warmformgebung erleichtern. Als Verfahren für das Aufbringen der jeweiligen Beschichtung eignet sich CVD ("Chemical Vapor Deposition"), CCVD ("Combustion Chemical Vapor Deposition") und PVD ("Physical Vapor Deposition"). Zur Erhöhung des Korrosionsschutzes können die verarbeiteten, vorzugsweise band- oder blechförmigen Rohlinge mit einer beliebigen metallischen Vorbeschichtung versehen werden, bevor die nichtmetallische Beschichtung gemäß der erläuterten ersten Variante aufgebracht wird.

Gemäß einer zweiten Variante der erfindungsgemäßen Beschichtung ist bei der Verarbeitung von jeweils aus Stahl bestehenden Rohlingen vorgesehen, dass wie bei der ersten Variante zunächst eine nichtmetallische Beschichtung auf das verarbeitete Substrat aufgebracht wird. Anschließend wird dann auf die nichtmetallische Beschichtung eine metallische Beschichtung aufgetragen.

Zur Verbesserung der Benetzung und Haftung der metallischen Beschichtung auf der Oxidschicht, Nitridschicht, Carbidschicht oder der Mehrkomponentenschichten kann eine dünne weitere metallische Zwischenschicht aufgebracht werden, die beispielsweise aus Fe oder Ni bestehen kann. Die metallische Deckschicht besteht aus Zn, ZnFe, ZnAl, Al, AlSi oder AlZnSi.

Die Schichtdicken der Oxidschichten, der Nitridschichten oder der Carbidschichten sowie der Mehrkomponentenschichten betragen 1 bis 1000 nm, bevorzugt 10 bis 100 nm. Als Verfahren für das Aufbringen der metallischen Schichten kommen CVD, CCVD und PVD in Frage. Die metallische Zwischenschicht sollte zwischen 0,05 bis 5 µm, bevorzugt 0,1 bis 1,0 µm betragen. Als Verfahren zum Auftragen kommen wiederum die schon erwähnten CVD-, CCVD- oder PVD-Verfahren sowie eine elektrolytische Abscheidung in Frage. Die metallische Deckschicht wird bevorzugt im Schmelztauchprozess mit Dicken von 2,5 µm bis 30 µm, bevorzugt 5 bis 20 µm erzeugt.

Durch die gemäß der zweiten Variante aufgebrachte erste Schicht wird eine Fe-Diffusion aus dem Stahl heraus verhindert. Die erste Schicht stellt insoweit eine Barriere dar, so dass die gemäß der zweiten Variante darüber aufgebrachte metallische Deckschicht ihre Eigenschaften unbeeinflusst von dem Substrat, welches sie trägt, beibehält. Dies ergibt einen besonders hohen Korrosionsschutz der gemäß dieser Variante der Erfindung mindestens zwei aufgebrachten Schichten. Für den Endverwender der derart erfindungsgemäß erzeugten Produkte ergibt sich dabei ein weiterer wesentlicher Vorteil. So können bei dieser Variante die bekannten und eingeführten Weiterverarbeitungsschritte wie z. B. das Aufbringen von Phosphat- und Lacksystemen oder das Kleben, beibehalten werden.

Gemäß einer dritten Variante der erfindungsgemäß auf das Rohteil aufgebrachten Beschichtung werden Schichtsysteme auf das Substrat aufgebracht, die im Bereich der erfindungsgemäß für die Warmverformung gewählt niedrigen Temperaturen spezielle Eigenschaften entwickeln. Besteht das Substrat aus einem Stahlwerkstoff, so können zu diesem Zweck auf das Stahlsubstrat Metallschichten aufgebracht werden, die aus Mn, Ni, Cr, Si oder Al sowie aus Mischsystemen der betreffenden Elemente gebildet sind. Die Schichtdicken sollten 10 nm bis 10 µm, bevorzugt 50 nm bis 5 µm betragen. Derart ausgebildete Schichten bilden bei einer Wärmebehandlung, die im Bereich von 450 °C bis 650 °C stattfindet, an der Oberfläche entweder Oxide, die dem Überzug gute Korrosionseigenschaften und hervorragende Umform- und Gleiteigenschaften verleihen oder es entstehen metallische Legierungen oder intermetallische Verbindungen, die den Stahl hervorragend gegen Korrosion schützen. Diese Effekte können auch jeweils in Kombination miteinander vorhanden sein. Die Beschichtung kann beispielsweise durch das PVD-Verfahren oder elektrolytische Abscheidungen aufgebracht werden. Die Einstellung der Eigenschaften der Beschichtung erfolgt während der Haltezeit auf Wärmebehandlungstemperatur, wobei die im Anschluss an die Warmverformung erfolgende Abkühlung keinen nennenswerten Einfluss mehr auf die Eigenschaften der Beschichtung hat. Die in dieser Weise erfindungsgemäß aufgebrachten Beschichtungen ermöglichen es somit, spannungsarme bzw. spannungsfreie Produkte zu erzeugen, die mit einem optimal harten und hochwirksamen Korrosionsschutz versehen sind.

Ein weiterer Typ von Beschichtungen, die während der Erwärmung auf Warmformtemperatur und der Umformung eine Änderung erfahren und spezielle Eigenschaften entwickeln, besteht bei Produkten, die aus Stahlwerkstoffen hergestellt sind, in den konventionellen Schmelztauchüberzügen. Da eine niedrige Temperatur zur Anwendung kommt, eignen sich zu diesem Zweck auch Zinküberzüge. Bei Temperaturbelastungen von 450 °C bis 650 °C kommt es zu einer Fe-Diffusion mit Bildung intermetallischer Phasen, wie sie sich in ähnlicher Weise bei der so genannten "Galvanneled"-Beschichtung einstellt. Kurzzeitwärmebehandlungen, die beispielsweise mit Hilfe induktiver Erwärmung durchgeführt werden, beeinflussen insbesondere bei niedrigen Temperaturen von ca. 450 °C den Überzug nur wenig. Alternativ sind an dieser Stelle aber auch die Al-haltigen Überzugsvarianten wie ZnAl, AlZnSi, AlSi und Al zu nennen, insbesondere wenn die Umformung im Bereich höherer Temperaturen von bis zu 700 °C, insbesondere oberhalb von 650 °C, durchgeführt wird. Auch bei dieser Vorgehensweise ist der bekanntermaßen hohe Korrosionsschutz von Beschichtungen der betreffenden Art gewährleistet. Die eingeführten Weiterverarbeitungsschritte beim Endverwender, wie z. B. das Aufbringen von Phosphat- und Lacksystemen oder das Kleben, können beibehalten werden. Geeignete Schichtdicken sind in diesem Fall 3 bis 30 µm, bevorzugt 5 bis 20 µm.

In den Bildern 1 bis 3 ist beispielhaft die Ausbildung einer auf einem feuerverzinkten Stahlsubstrat S aufgebrachten Zink-Überzugsschicht Z bei 400 °C (Bild 1), 500 °C (Bild 2) und 600 °C (Bild 3) dargestellt. Es zeigt sich, dass bei einer Verformungstemperatur von 400 °C keine Änderung des Überzugs eintritt, während bei 500 °C die Legierungsbildung einsetzt und bei 600 °C die Durchlegierung erreicht ist.

Nachfolgend wird die Erfindung anhand von Ausführungsbeispielen näher erläutert.

In sechs Versuchen 1 bis 6 sind zunächst jeweils aus Stahlwerkstoffen bestehende Bleche als Rohteile eingesetzt und zu einem Produkt warmverformt worden. In der Tabelle 1 sind die Gehalte der neben Eisen wesentlichen Legierungselemente des jeweils verarbeiteten Stahls, die jeweilige Verformungstemperatur Tᵥ, der Umformgrad U, die Formänderungsfestigkeit Fₐₑ und die Bruchdehnung A_{w} des auf Verformungstemperatur Tᵥ erwärmten Rohteils, sowie die mechanischen Eigenschaften "Streckgrenze Rₑ", "Zugfestigkeit Rₘ" und "Bruchdehnung A" des fertig verformten Produkts angegeben.

Die Versuche 1 bis 6 zeigen, dass bei erfindungsgemäß niedriger Umformtemperatur die Formänderungsfestigkeiten ungefähr auf die Hälfte reduziert werden können und die durch die Bruchdehnung gekennzeichnete Verformbarkeit deutlich gesteigert werden kann.

In zwei weiteren Versuchen 7 und 8 ist der Gesamtumformprozess auf zwei Schritte aufgeteilt worden. Selbstverständlich ist auch eine Aufteilung auf mehrere Schritte möglich. In Tabelle 2 sind wiederum die Gehalte der neben Eisen wesentlichen Legierungselemente des jeweils verarbeiteten Stahls, die Verformungstemperatur Tᵥ₁ beim ersten Umformschritt, der Umformgrad U₁ beim ersten Umformschritt, die Verformungstemperatur Tᵥ₂ beim zweiten Umformschritt, der Umformgrad U₂ beim zweiten Umformschritt, die Formänderungsfestigkeit Fₐₑ und die Bruchdehnung A_{w} des Produkts bei der im warmen Zustand erfolgenden Umformung, sowie die mechanischen Eigenschaften "Streckgrenze Rₑ", "Zugfestigkeit Rₘ" und "Bruchdehnung A" des fertig verformten Produkts angegeben.

Es zeigt sich, dass durch die Aufteilung in jeweils einen warmen und einen kalten Umformschritt die Gesamtumformung deutlich gesteigert werden kann. Beim Beispiel 7 ist die erfindungsgemäße Warmverformung, die auch in diesem Fall bei einer verglichen mit dem Stand der Technik niedrigen Temperatur erfolgt, im zweiten Schritt durchgeführt worden, während sie beim Beispiel 8 im ersten Schritt erfolgt. Auf diese Weise lassen sich komplizierte und besonders formsteife Produkte herstellen.

Die Versuche zeigen, dass bei erfindungsgemäßer Vorgehensweise im abgekühlten Endzustand ein weites Spektrum an Festigkeitswerten bis über 1000 MPa bei gutem Restverformungsvermögen erzielt wird.

Zum Nachweis der Wirksamkeit erfindungsgemäß vorgesehener Beschichtungen sind zu den drei Beschichtungsvarianten Versuche auf Grund von Stahlbändern durchgeführt worden, deren Zusammensetzung den Zusammensetzungen der in den Tabellen 1 und 2 genannten Stähle entsprachen.

In einem ersten Versuch ist dabei die erste Beschichtungsvariante untersucht worden, bei der der Überzug nicht metallisch ist und vor der Warmverformung bereits eine hohe Härte besitzt, die nach Beendigung der Warmverformung über die anschließende Abkühlung im Wesentlichen konstant bleibt. Im Zuge des Versuches ist das warmgewalzte Stahlband zunächst zur Entfernung des Zunders kontinuierlich gebeizt und in einer Feuerbeschichtungsanlage aluminiert worden. In einem darauf folgenden Schritt ist auf die aluminierte Oberfläche des Bandes eine 50 nm dicke Si-Oxidschicht mittels CCVD aufgebracht worden. Aus dem mit dieser Beschichtung versehenen Stahlband sind dann Zuschnitte hergestellt worden, die als Rohteile in einem Wärmeofen auf eine Verformungstemperatur von 650 °C erwärmt worden sind, bei der sie für 5 min. gehalten worden sind. Im unmittelbaren Anschluss an das Verlassen des Wärmeofens sind die auf Verformungstemperatur erwärmten Rohteile umgeformt und an Luft langsam abgekühlt worden. Der an der äußeren Oberfläche vorliegende oxidische Überzug ist durch die Wärme- und Umformbehandlung nicht verändert worden und schützt so den metallischen Überzug und den darunterliegenden Stahl vor Oxidation bzw. Entkohlung. Der metallische Überzug wird dadurch stabiler gegen mechanische Beanspruchung, so dass ein Abplatzen des Überzuges während und nach dem Umformprozess sicher vermieden wird. Darüber hinaus erleichtert die äußere Schicht durch ihre hervorragenden Gleiteigenschaften das Umformen. Die hohe Härte der äußeren Schicht verleiht dem Schichtsystem zusätzlich eine hohe Stoß- und Kratzfestigkeit. Die metallische Veredelung sorgt für einen hervorragenden Korrosionsschutz.

Zum Nachweis der Wirksamkeit der zweiten Variante der erfindungsgemäß vorgesehenen Beschichtung ist ein kaltgewalztes Stahlband in einer kontinuierlichen Feuerbeschichtungsanlage zunächst gereinigt worden. In einem anschließenden Prozess ist eine 50 nm dicke Cr-Oxidschicht mittels PVD aufgebracht worden. Danach erfolgte in einem weiteren Verfahrensschritt das Aufbringen einer dünnen, 1 µm dicken Fe-Schicht mittels elektrolytischer Abscheidung. Das Kaltband ist dann rekristallisierend geglüht und in einem Schmelzbad aus AlSi beschichtet worden. Das fertig beschichtete Stahlband ist dann zu Zuschnitten konfektioniert worden, die in einem Wärmeofen auf eine Verformungstemperatur von 600 °C erwärmt worden sind, bei der sie für 1 min. gehalten worden sind. Die derart erwärmten Rohteile sind unmittelbar im Anschluss an das Verlassen des Wärmeofens bei der Verformungstemperatur umgeformt und anschließend an Luft langsam und ungesteuert abgekühlt worden. Der an der Grenze zwischen dem Stahl und dem Überzugsystem vorliegende oxidische Überzug verhindert, dass während der Wärmebehandlung im metallischen Überzug eine Fe-Diffusion stattfindet. Die typischen Eigenschaften des äußeren metallischen Überzuges bleiben auf diese Weise erhalten, so dass bei der weiteren Verarbeitung der derart durch derartige Warmumformung erzeugten beschichteten Produkte problemlos eine Phosphatierung oder Lackierung konventionell durchgeführt werden kann.

Zum Nachweis der Wirksamkeit der dritten Variante erfindungsgemäß vorgesehener Beschichtungen ist ein warmgewalztes Stahlband zunächst zur Entfernung des Zunders kontinuierlich gebeizt worden. In einem anschließenden PVD-Prozess ist eine 100 nm dicke AlSiCr-Schicht aufgebracht worden. Das derart beschichtete Warmband ist dann zu Zuschnitten konfektioniert worden, die als Rohteile in einem Wärmeofen auf eine Temperatur von 600 °C gebracht worden sind, bei der sie für 1 min. gehalten worden sind. Die derart auf Verformungstemperatur erwärmten Rohteile sind dann im unmittelbaren Anschluss an das Verlassen des Wärmeofens zu Produkten umgeformt und ungesteuert an Luft abgekühlt worden. Durch die Wärmebehandlung entstehen bei dieser Variante an der Oberfläche Oxidschichten, die dem Überzug hervorragende Umform- und Gleiteigenschaften verleihen. Weiterhin schützt der Überzug den Stahl vor Oxidation und Entkohlung und bietet einen guten Korrosionsschutz.

In einem weiteren Versuch zu der dritten Variante der erfindungsgemäß vorgesehenen Beschichtung ist zunächst wiederum ein warmgewalztes Stahlband zur Entfernung des Zunders kontinuierlich gebeizt worden. In einem anschließenden elektrolytischen Prozess ist eine 3 µm dicke Ni-Schicht aufgebracht worden. Aus dem beschichteten Warmband sind dann als Rohteile Zuschnitte hergestellt worden, die in einem Wärmeofen auf eine Temperatur von 550 °C erwärmt worden sind, bei der sie für 1 min. gehalten worden sind. Die derart auf die Warmverformungstemperatur erwärmten Rohteile sind im unmittelbaren Anschluss an das Verlassen des Wärmeofens umgeformt und anschließend erfindungsgemäß abgekühlt worden. Durch die Wärmebehandlung ist ein metallischer/intermetallischer Überzug entstanden, der den Stahl hervorragend vor Korrosion schützt.

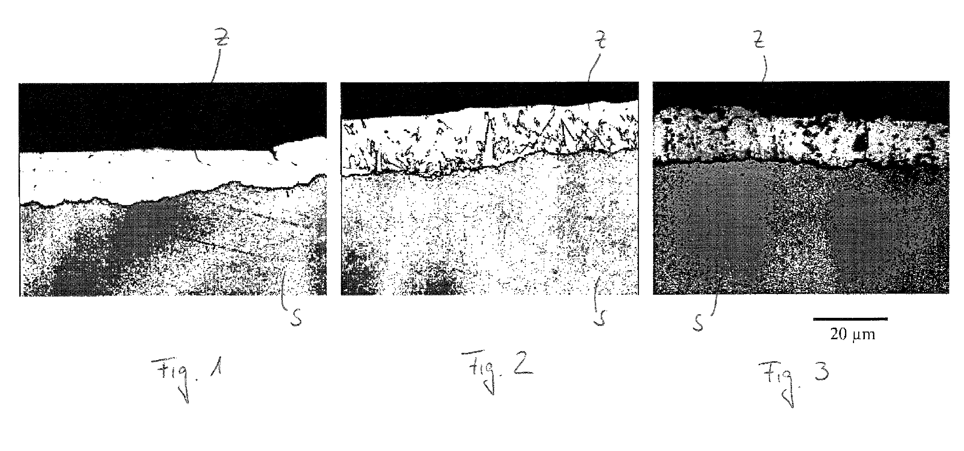

Schließlich ist ebenfalls zur Demonstration der Wirkung der dritten Variante der erfindungsgemäß vorgesehenen Beschichtung ein warmgewalztes Stahlband entzundert und anschließend in einem Schmelztauchprozess mit einer 10 µm dicken Zn-Schicht versehen worden. Aus dem beschichteten Warmband sind Zuschnitte hergestellt worden, die als Rohteile induktiv auf eine Temperatur von 500 °C erwärmt worden sind, bei der sie für 10 s gehalten worden sind. Die derart auf Verformungstemperatur verformten Teile sind unmittelbar anschließend umgeformt und ungesteuert abgekühlt worden. Durch die Wärmebehandlung wandelt der Überzug nur teilweise (Bild 2) eine ZnFe-Legierung um. Durch Erhöhung der Verformungstemperatur kann eine vollständige Umwandlung erreicht werden (Bild 3). Der Überzug schützt den Stahl vor Oxidation und Entkohlung und bietet einen bekanntermaßen sehr guten Korrosionsschutz.

**Tabelle 1**

| | Legierung^{*)} [Gew.-%] | | Tᵥ [°C] | U [%] | Fₐₑ [MPa] | A_{w} [%] | Rₑ [MPa] | Rₘ [MPa] | A [%] |
|---|---|---|---|---|---|---|---|---|---|
| 1 | C: | 0,10 | 600 | 30 | 380 | 20 | 770 | 810 | 14 |
| | Si: | 0,23 | | | | | | | |
| | Mn: | 1, 93 | | | | | | | |
| | Ti: | 0,16 | | | | | | | |
| | Nb: | 0,04 | | | | | | | |
| 2 | C: | 0,21 | 500 | 30 | 260 | 35 | 482 | 820 | 26 |
| | Si: | 1,45 | | | | | | | |
| | Mn: | 1,52 | | | | | | | |
| 3 | C: | 0,08 | 500 | 30 | 185 | 35 | 375 | 460 | 18 |
| | Si: | 0,15 | | | | | | | |
| | Mn: | 1,52 | | | | | | | |
| | Nb: | 0,04 | | | | | | | |
| 4 | C: | 0,04 | 500 | 30 | 145 | 50 | 225 | 315 | 38 |
| | Mn: | 0,13 | | | | | | | |
| 5 | C: | 0,60 | 500 | 30 | 285 | 50 | 520 | 1003 | 14 |
| | Si: | 0,25 | | | | | | | |
| | Mn: | 0,75 | | | | | | | |
| 6 | Al-Legierung | | 220 | 30 | 65 | 40 | 180 | 310 | 23 |

| | | | | | | | | | |
|---|---|---|---|---|---|---|---|---|---|
| *) Rest Eisen und unvermeidbare Verunreinigungen | | | | | | | | | |

**Tabelle 2**

| | Legierung¹⁾ [Gew.-%] | | Tᵥ₁ [°C] | U₁ [%] | Tᵥ₂ [°C] | U₂ [%] | Fae [MPa] | AW [%] | Re [MPa] | Rm [MPa] | A [%] |
|---|---|---|---|---|---|---|---|---|---|---|---|
| 7 | C: | 0,10 | RT²⁾ | 10 | 600 | 30 | 380 | 20 | 770 | 810 | 14 |
| | Si: | 0,23 | | | | | | | | | |
| | Mn: | 1, 93 | | | | | | | | | |
| | Ti: | 0,16 | | | | | | | | | |
| | Nb: | 0,04 | | | | | | | | | |
| 8 | C: | 0,04 | 500 | 30 | RT²⁾ | 30 | 145 | 50 | 225 | 315 | 38 |

| | | | | | | | | | | | |
|---|---|---|---|---|---|---|---|---|---|---|---|
| ¹) Rest Eisen und unvermeidbare Verunreinigungen ²) RT = Raumtemperatur | | | | | | | | | | | |

## Patentansprüche

1. Verfahren zum Herstellen eines Produkts aus einem mindestens auf einer seiner Außenflächen verzinkten Stahlblech, bei dem folgende Schritte durchlaufen werden:
- Erwärmen des Stahlblechs auf eine Verformungstemperatur, die 450 °C bis 700 °C beträgt,
- Umformen des auf Verformungstemperatur erwärmten Stahlblechs zu dem Produkt,
- ungesteuertes langsames Abkühlen des Produkts auf Raumtemperatur,
- wobei die Eigenschaften des Werkstoffs, aus dem der Rohling hergestellt ist, und die Verformungstemperatur so aufeinander abgestimmt sind, dass das erhaltene Produkt hinsichtlich mindestens eines Kennwerts seiner mechanischen Eigenschaften gegenüber dem Rohling verbessert ist.

2. Verfahren nach Anspruch 1, **dadurch gekennzeichnet, dass** der Kennwert der mechanischen Eigenschaften des Produktes nach Beendigung des Umformvorgangs im Wesentlichen konstant bleibt.

3. Verfahren nach Anspruch 1, **dadurch gekennzeichnet, dass** der Kennwert der mechanischen Eigenschaften des Produktes nach Beendigung des Umformvorgangs ansteigt.

4. Verfahren nach einem der voranstehenden Ansprüche,
**dadurch gekennzeichnet, dass** der Rohling vor der Umformung vorverformt wird.

5. Verfahren nach einem der voranstehenden Ansprüche, **dadurch gekennzeichnet, dass** die Abkühlung des fertig warmumgeformten Produkts ungesteuert an ruhender Luft erfolgt.

6. Verfahren nach einem der voranstehenden Ansprüche, **dadurch gekennzeichnet, dass** der Rohling nach Erreichen der Verformungstemperatur für ein bestimmtes Zeitintervall auf der Verformungstemperatur gehalten wird, bevor er warmumgeformt wird.

7. Verfahren nach einem der voranstehenden Ansprüche, **dadurch gekennzeichnet, dass** der Rohling zunächst auf eine über der Verformungstemperatur liegende Überhöhungstemperatur aufgeheizt und anschließend auf die Verformungstemperatur abgekühlt wird.

8. Verfahren nach einem der Ansprüche 6 oder 7, **dadurch gekennzeichnet, dass** die Verformungstemperatur höchstens 650 °C beträgt.

9. Verfahren nach einem der voranstehenden Ansprüche, **dadurch gekennzeichnet, dass** das nach dem Abkühlen erhaltene Produkt bei Raumtemperatur einer weiteren Verformung unterzogen wird.

10. Verfahren nach einem der voranstehenden Ansprüche, **dadurch gekennzeichnet, dass** der Rohling ein warmgewalztes Stahlblech ist.

11. Verfahren nach einem der Ansprüche 1 bis 9, **dadurch gekennzeichnet, dass** der Rohling ein kaltgewalztes Stahlblech ist.
